(19) Europäisches Patentamt
European Patent Office
Office européen des brevets

(11) **EP 3 139 502 B1**

(12) **EUROPEAN PATENT SPECIFICATION**

(45) Date of publication and mention
of the grant of the patent:
**01.04.2020 Bulletin 2020/14**

(51) Int Cl.:
***H03F 3/45*** *(2006.01)*   ***H03F 1/26*** *(2006.01)*
***H03F 1/32*** *(2006.01)*

(21) Application number: **16186698.3**

(22) Date of filing: **31.08.2016**

(54) **SINGLE-ENDED TO DIFFERENTIAL CONVERSION CIRCUIT AND SIGNAL PROCESSING MODULE**

EINFACHEND-DIFFERENZIALUMWANDLUNGSSCHALTUNG UND
SIGNALVERARBEITUNGSMODUL

CIRCUIT DE CONVERSION ASYMÉTRIQUE-DIFFÉRENTIEL ET MODULE DE TRAITEMENT DE
SIGNAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.09.2015 US 201562214103 P
01.07.2016 US 201615200045**

(43) Date of publication of application:
**08.03.2017 Bulletin 2017/10**

(73) Proprietor: **MediaTek Inc.
Hsin-Chu 300 (TW)**

(72) Inventors:
• **Lin, Yu-Hsin
104 Taipei City (TW)**
• **Wang, Tze-Chien
302 Hsinchu County (TW)**

(74) Representative: **Wright, Howard Hugh Burnby et al
Withers & Rogers LLP
4 More London Riverside
London SE1 2AU (GB)**

(56) References cited:
**WO-A1-00/41297      WO-A1-89/10656
DE-A1- 4 104 714      US-B1- 6 359 505**

**Description**

**BACKGROUND OF THE INVENTION**

**Field of the Invention**

The invention relates to a single-ended to differential conversion circuit, and more particularly to a signal processing module with a single-ended to differential conversion circuit for converting an input signal into a pair of differential output signals.

**Description of the Related Art**

Currently, analog to digital converters (ADCs) are used widely in a variety of applications, such as medical systems, audio systems, test and measurement equipment, communication systems, and image and video systems. In recent years, the differential input ADCs have been used in instrumentation or communications systems. This is because the signal amplitude of a differential input is half that of a single-ended input. Therefore, distortion is decreased and the even-order distortion and the in-phase component noise that are generated by circuits in front of the ADC are canceled by the differential input of the ADC. Thus, it is possible to realize the properties of broad band, low noise, and low distortion.

Therefore, for the performance of the ADC, when the input signals are single-ended signals, it is necessary to set up in front of the ADC a signal converter that converts single-ended signals into differential signals. An example of such single-ended to differential converter can be found in patent document WO 00/41297 A1.

**BRIEF SUMMARY OF THE INVENTION**

A single-ended to differential conversion circuit and a signal processing is provided according to appended claim 1.

**BRIEF DESCRIPTION OF DRAWINGS**

The invention can be more fully understood by reading the subsequent detailed description and examples with references made to the accompanying drawings, wherein:

FIG. 1 shows a signal processing module according to an embodiment of the invention; and
FIG. 2 shows a signal processing module according to another embodiment of the invention.

**DETAILED DESCRIPTION OF THE INVENTION**

The following description is of the best-contemplated mode of carrying out the invention. This description is made for the purpose of illustrating the general principles of the invention and should not be taken in a limiting sense. The scope of the invention is best determined by reference to the appended claims.

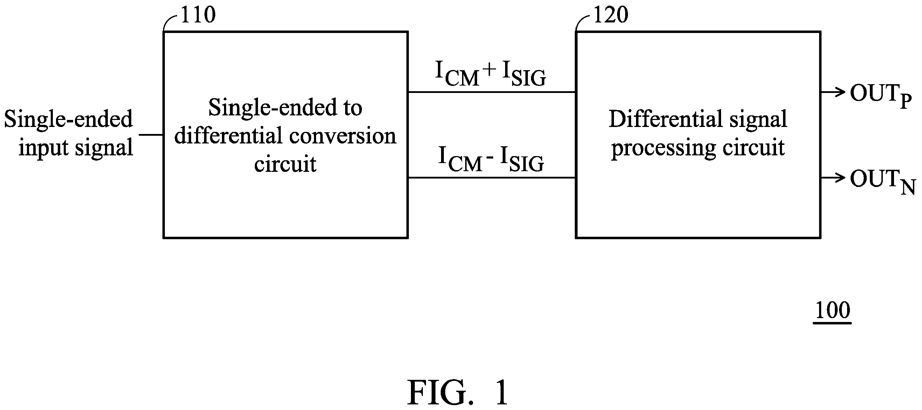

FIG. 1 shows a signal processing module 100 according to an embodiment of the invention. The signal processing module 100 comprises a single-ended to differential conversion circuit 110 and a differential signal processing circuit 120. The single-ended to differential conversion circuit 110 is capable of converting a single-ended input signal into a pair of intermediate signals (labeled as the differential current signals $I_{CM}+I_{SIG}$ and $I_{CM}-I_{SIG}$, wherein $I_{CM}$ represents the DC component and $I_{SIG}$ represents the AC component). In some embodiments, the pair of intermediate signals may be the voltage signals, and the single-ended to differential conversion circuit 110 is capable of converting the single-ended input signal into the voltages (e.g. the differential voltage signals $V_{CM}+V_{SIG}$ and $V_{CM}-V_{SIG}$) corresponding to the pair of intermediate signals. The differential signal processing circuit 120 is capable of processing the pair of intermediate signals and providing a pair of differential output signals $OUT_P/OUT_N$ according to the pair of intermediate signals (e.g. $I_{CM}+I_{SIG}$ and $I_{CM}-I_{SIG}$). For example, in some embodiments, the differential signal processing circuit 120 amplifies the pair of intermediate signals (e.g. $I_{CM}+I_{SIG}$ and $I_{CM}-I_{SIG}$) to obtain the pair of differential output signals OUTp/OUTN. As another example, in some embodiments, the differential signal processing circuit 120 modifies the pair of intermediate signals (e.g. $I_{CM}+I_{SIG}$, $I_{CM}-I_{SIG}$) according to a modification signal (not shown) to obtain the pair of differential output signals $OUT_P/OUT_N$. It should be noted that the operation of the differential signal processing circuit 120 is used as an example, and not to limit the invention.

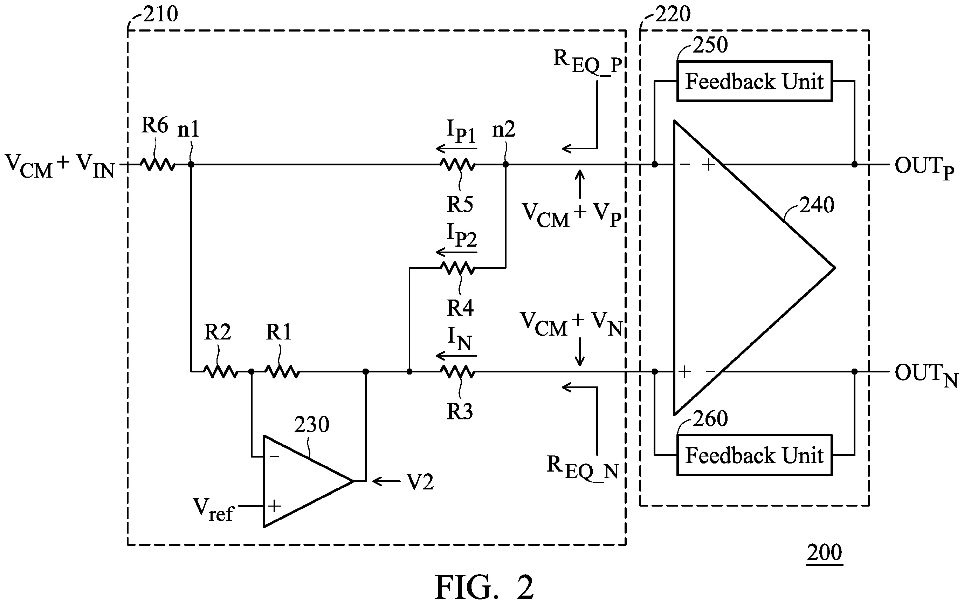

FIG. 2 shows a signal processing module 200 according to another embodiment of the invention. The signal processing module 200 comprises a single-ended to differential conversion circuit 210 and a differential signal processing circuit 220. The single-ended to differential conversion circuit 210 is capable of converting a single-ended input signal

$V_{CM}+V_{IN}$ into a pair of differential intermediate signals. In the embodiment, the pair of differential intermediate signals are a pair of differential current signals (e.g. the current $(I_{P1}+I_{P2})$ at the node n2 and the current $-I_N$ at the node n3 in FIG. 2). It should be noted that, $V_{CM}$ may represent a DC voltage, and $V_{IN}$ may represent an AC component containing the AC voltage. For example, when $V_{CM}= 0V$, $V_{IN}$ can be used to represent a pure AC signal without a DC component. Of course, $V_{IN}$ can also be used to represent an AC signal with a DC component. In particular, the embodiments are used as the examples, and not to limit the invention. In the embodiment, the single-ended to differential conversion circuit 210 comprises an amplifier 230 (as shown in FIG. 2, the amplifier 230 is a single-ended amplifier), and six resistors R1-R6. In some embodiments, the resistor R6 could be omitted. In other words, the resistor R6 is optional. The differential signal processing circuit 220 comprises a fully-differential amplifier 240, and two feedback units 250 and 260. The feedback unit 250 is coupled between an inverting input terminal and a non-inverting output terminal of the fully-differential amplifier 240, and the feedback unit 260 is coupled between a non-inverting input terminal and an inverting output terminal of the fully-differential amplifier 240. In some embodiments, the differential signal processing circuit 220 further comprises two input units (not shown), wherein one input unit is coupled between the inverting input terminal of the fully-differential amplifier 240 and a node n2 of the single-ended to differential conversion circuit 210 (for example, between one differential output terminal of the single-ended to differential conversion circuit 210 and the inverting input terminal of the fully-differential amplifier 240), and another input unit is coupled between the non-inverting input terminal of the fully-differential amplifier 240 and the resistor R3 of the single-ended to differential conversion circuit 210 (for example, between the other differential output terminal of the single-ended to differential conversion circuit 210 and the non-inverting input terminal of the fully-differential amplifier 240). Thus, a gain is determined according to the input units and the feedback units 250 and 260 for the fully-differential amplifier 240. In practice, if the fully-differential amplifier 240 is an ideal amplifier, the input voltages of its inverting input terminal and its non-inverting input terminal are equal. If the fully-differential amplifier 240 is a non-ideal amplifier, the input voltages of its inverting input terminal and its non-inverting input terminal are the differential voltages. In the embodiment, no matter whether the fully-differential amplifier 240 is an ideal amplifier, the two input currents of the fully-differential amplifier 240 are the differential currents. Therefore, in the embodiment, for the convenience of explanation, the differential intermediate signals are the differential current signals, and the fully-differential amplifier 240 is an ideal amplifier 240. It should be noted that the specific type of the fully-differential amplifier 240 is used as an example, and not to limit the invention. The reason is that, for a particular type of fully-differential amplifier 240, the fully-differential amplifier 240 will automatically adjust the voltages of its input terminals, such that the voltages of the input terminals can meet the objective requests of the particular type of fully-differential amplifier. In the embodiment, for the convenience of description, the voltages of two input terminals of the fully-differential amplifier 240 are maintained at the voltage $V_{CM}$ (i.e. the voltage Vn2 of the node n2 and the voltage $V_{n3}$ of the node n3 are equal to the voltage $V_{CM}$, e.g. $V_{n2}=V_{n3}=V_{CM}$), and it should be noted that the invention is not limited thereto.

In the single-ended to differential conversion circuit 210 of FIG. 2, the amplifier 230 has an inverting input terminal coupled to a terminal of the resistor R1 and a terminal of the resistor R2, a non-inverting input terminal for receiving a reference signal $V_{ref}$, and an output terminal coupled to another terminal of the resistor R1, a terminal of the resistor R3, and a terminal of the resistor R4. In some embodiments, the reference signal $V_{ref}$ has a constant voltage value. For example, the voltage level of the reference signal $V_{ref}$ is equal to that of the DC voltage $V_{CM}$. For convenience of description, the reference signal $V_{ref}$ is equal to that the DC voltage $V_{CM}$ in the embodiment, and it should be noted that the invention is not limited to this. Because, if the voltage level of the DC voltage $V_{CM}$ is not equal to that of the reference signal $V_{ref}$, $V_{IN}$ can be replaced by $(V_{CM}-V_{ref} + V_{IN})$. Thus, based on the following embodiments, the resistance value of the resistor R3, and the equivalent impedance of the single-ended to differential conversion circuit 210 can be obtained accordingly. The resistor R6 is coupled to a node n1, and the resistor R6 is an input resistor for receiving the input signal $V_{IN}$. The resistor R2 is coupled between the node n1 and the inverting input terminal of the amplifier 230, and the inverting input terminal of the amplifier 230 can receive the input signal $V_{IN}$ via the resistor R2. The resistor R1 is coupled between the inverting input terminal and the output terminal of the amplifier 230. The resistor R3 is coupled between the output terminal of the amplifier 230 and the non-inverting input terminal of the fully-differential amplifier 240. The resistor R4 is coupled between the output terminal of the amplifier 230 and the node n2. The resistor R5 is coupled between the node n2 and the node n1. Furthermore, the resistors R4 and R5 form a resistor string coupled between the node n1 and the output terminal of the amplifier 230. In some embodiments, the resistance value of the resistor R3 is determined according to the resistors R1, R2, R4 and R5.

In one embodiment, the resistance (or impedance) of the resistor R5 is R, which is a unit resistance for the single-ended to differential conversion circuit 210. The resistance of the resistor R6 is $m \times R$. The resistance of the resistor R2 is $x \times R$. The resistance of the resistor R1 is $y \times R$. The resistance of the resistor R4 is $n \times R$. According to the resistances of the resistors R1, R2, R4 and R5, the resistance of the resistor R3 is obtained according to the following formula (1):

$$R3 = \frac{\frac{y}{x}}{1 - \frac{y}{x}\frac{1}{n}} \times R \qquad (1).$$

Furthermore, according to a virtual ground concept of circuit analysis in operational amplifier, the nodes at the non-inverting input terminal and inverting input terminal of the amplifier 230, and the nodes at the non-inverting input terminal and inverting input terminal of the fully-differential amplifier 240 are maintained at a steady reference potential (i.e. a virtual ground). Thus, a voltage $V_{n1}$ at the node n1 is obtained according to the following formula (2):

$$V_{n1} = V_{CM} + V1 = V_{CM} + \frac{\frac{x}{1+x}}{m + \frac{x}{1+x}} \times V_{IN} \qquad (2),$$

wherein

$$V1 = \frac{\frac{x}{1+x}}{m + \frac{x}{1+x}} \times V_{IN} \qquad .$$

Furthermore, according to the voltage $V_{n1}$ at the node n1, and the resistors R1 and R2, a voltage V2 at the output terminal of the amplifier 230 is obtained according to the following formula (3):

$$V2 = V_{CM} - \frac{y}{x} \times V1 \qquad (3).$$

According to the voltages $V_{n1}$, $V_{n2}$ and V2, the current $I_{p1}$ flowing through the resistor R5, the current $I_{p2}$ flowing through the resistor R4, and current $I_N$ flowing through the resistor R3 are respectively obtained according to the following formulas (4)-(6):

$$I_{P1} = -\frac{V_1}{R} \qquad (4);$$

$$I_{P2} = \frac{\frac{y}{x} \times V1}{n \cdot R} \qquad (5);$$

and

$$I_N = \frac{\frac{y}{x} \times VI}{\frac{y}{x} \times R} = \left(1 - \frac{y}{x} \cdot \frac{1}{n}\right) \times \frac{V_1}{R} = -(I_{P1} + I_{P2})$$
$$\quad\quad\quad 1 - \frac{y}{x} \cdot \frac{1}{n}$$

$$(6).$$

From the formulas (4) - (6), by appropriately setting the resistance value of the resistor R3, the output currents of the single-ended to differential conversion circuit 210 are always a pair of differential signals based on the architecture shown in FIG. 2, i.e. $I_N = -(I_{P1} + I_{P2})$. Furthermore, by determining the relationship between the voltage/current of the inverting input terminal and the voltage/current of the non-inverting input terminal of the fully-differential amplifier 240, a common mode or a differential mode is determined for the signal processing module 200, so as to estimate the common mode or differential mode perturbations for the pair of intermediate signals, and then the equivalent impedance $R_{EQ\_P}$ observed at the inverting input terminal of the fully-differential amplifier 240 (in other words, observing the single-ended to differential conversion circuit 210 from the inverting input terminal of the fully-differential amplifier 240) and the equivalent impedance $R_{EQ\_N}$ observed at the non-inverting input terminal of the fully-differential amplifier 240 are obtained (in other words, observing the single-ended to differential conversion circuit 210 from the non-inverting input terminal of the fully-differential amplifier 240). In some embodiments, the equivalent impedances $R_{EQ\_P}$ and $R_{EQ\_N}$ may be set to the same. In some embodiments, the equivalent impedances $R_{EQ\_P}$ and $R_{EQ\_N}$ are the output impedances for the single-ended to differential conversion circuit 210.

In order to calculate the output impedances, the voltages $V_{CM}+V_P$ and $V_{CM}+V_N$ are applied to the output terminals of the single-ended to differential conversion circuit 210, without receiving the single-ended input signal at its input terminal. For example, in order to calculate the common mode output impedances of the single-ended to differential conversion circuit 210), the voltage $V_{CM}+V_P$ applied to the inverting input terminal and the voltage $V_{CM}+V_N$ applied to the non-inverting input terminal of the fully-differential amplifier 240 are assumed to be the same, i.e. $V_P = V_N$. Furthermore, in a common mode, if the equivalent impedances $R_{EQ\_P}$ and $R_{EQ\_N}$ are equal, a current from the inverting input terminal of the fully-differential amplifier 240 to the single-ended to differential conversion circuit 210 is equal to a current from the non-inverting input terminal of the fully-differential amplifier 240 to the single-ended to differential conversion circuit 210, i.e.

$I_{P1} + I_{P2} = I_N$. Thus, the equivalent impedances $R_{EQ\_P}$ and $R_{EQ\_N}$ are obtained according to the following formulas (7)-(8):

$$R_{EQ\_P} = \frac{1}{1 + \frac{m \cdot x}{m + x}} + \frac{1}{n}\left(1 + \frac{y}{x} \cdot \frac{\frac{m \cdot x}{m + x}}{1 + \frac{m \cdot x}{m + x}}\right)$$

$$(7);$$

and

$$R_{EQ\_N} = \frac{1 + \frac{y}{x} \cdot \frac{\frac{m \cdot x}{m + x}}{1 + \frac{m \cdot x}{m + x}}}{\frac{y}{x}}$$
$$\quad\quad\quad\quad 1 - \frac{y}{x} \cdot \frac{1}{n}$$

$$(8).$$

When $\dfrac{1}{1+\dfrac{m \cdot x}{m+x}} + \dfrac{1}{n}\left(1 + \dfrac{y}{x} \cdot \dfrac{\dfrac{m \cdot x}{m+x}}{1+\dfrac{m \cdot x}{m+x}}\right) = \dfrac{1 + \dfrac{y}{x} \cdot \dfrac{\dfrac{m \cdot x}{m+x}}{1+\dfrac{m \cdot x}{m+x}}}{\dfrac{\dfrac{y}{x}}{1-\dfrac{y}{x} \cdot \dfrac{1}{n}}}$ is satisfied, the equivalent impedances

$R_{EQ\_P}$ and $R_{EQ\_N}$ are the same in the common mode.

Correspondingly, in order to calculate the differential mode output impedances of the single-ended to differential conversion circuit 210, the voltage $V_{CM}+V_P$ applied to the inverting input terminal and the voltage $V_{CM}+V_N$ applied to the non-inverting input terminal of the fully-differential amplifier 240 are the differential signals, e.g. $V_P = -V_N$. Furthermore, in a differential mode, if the equivalent impedances $R_{EQ\_P}$ and $R_{EQ\_N}$ are equal, a current from the single-ended to differential conversion circuit 210 to the inverting input terminal of the fully-differential amplifier 240 is equal to a current from the non-inverting input terminal of the fully-differential amplifier 240 to the single-ended to differential conversion circuit 210, i.e. $I_{P1}+I_{P2}=-I_N$. Thus, the equivalent impedances $R_{EQ\_P}$ and $R_{EQ\_N}$ are obtained according to the following formulas (9)-(10):

$$R_{EQ\_P} = \frac{1}{1+m\,\|\,x} + \frac{1}{n}\left(1 + \frac{y}{x}\frac{m\,\|\,x}{1+m\,\|\,x}\right) \quad (9);$$

and

$$R_{EQ\_N} = \frac{1 - \dfrac{y}{x}\dfrac{m\,\|\,x}{1+m\,\|\,x}}{\dfrac{\dfrac{y}{x}}{1-\dfrac{y}{x}\dfrac{1}{n}}} \quad (10).$$

When $\dfrac{1}{1+\dfrac{m \cdot x}{m+x}} + \dfrac{1}{n}\left(1 + \dfrac{y}{x} \cdot \dfrac{\dfrac{m \cdot x}{m+x}}{1+\dfrac{m \cdot x}{m+x}}\right) = \dfrac{1 - \dfrac{y}{x} \cdot \dfrac{\dfrac{m \cdot x}{m+x}}{1+\dfrac{m \cdot x}{m+x}}}{\dfrac{\dfrac{y}{x}}{1-\dfrac{y}{x} \cdot \dfrac{1}{n}}}$ is satisfied, the equivalent impedances

$R_{EQ\_P}$ and $R_{EQ\_N}$ are the same in the differential mode.

It should be noted that if the common-mode output impedances or the differential mode output impedances are respectively equal, the absolute value of the sum of the currents I1 and I2 is equal to the absolute value of the current I3, i.e. $|I_{P1}+I_{P2}|=|I_N|$. Furthermore, according to actual application, the equivalent impedances $R_{EQ\_P}$ and $R_{EQ\_N}$ can be obtained for a common mode or a differential mode perturbation. Typically, it can not meet that the common-mode equivalent impedances and the differential-mode equivalent impedances are respectively equal. Specifically, according to actual requirements, it is possible to set that the common-mode equivalent impedances are equal or the differential-mode equivalent impedances are equal, and the invention does not make this any limitation. For example, since the circuit (e.g. the single-ended to differential conversion circuit 110) disposed in front of the differential signal processing circuit 120 usually has a common-mode noise, the common-mode noise can be cancelled between the two differential input terminals of the fully-differential amplifier 240 by setting the equivalent impedances $R_{EQ\_P}$ and $R_{EQ\_N}$ are the same in the common mode, thereby decreasing noise. For another example, by setting the equivalent impedances $R_{EQ\_P}$ and $R_{EQ\_N}$ are the same in the differential mode, distortion is decreased in the applications with a differential mode feedback.

By adding the resistor R4 between the node n2 and the output terminal of the amplifier 230, only a single single-ended amplifier (i.e. the amplifier 230) is used in the single-ended to differential conversion circuit 210. Thus, compared with the conventional single-ended to differential conversion circuits (e.g. using two single-ended amplifiers solution, or a fully-differential amplifier solution, and so on), the layout area and the power consumption are decreased in the single-ended to differential conversion circuit 210. Furthermore, trade-off between the input magnitude of the single-ended input signal and the performance of the amplifier 230 can be optimized. With the introduction of the resistor R4 (e.g. a resistance of $n \times R$), the equivalent input is scaled by 1-1/$n$ (n>1), and the non-idealities of the amplifier 230 can be cancelled to be $|1/n-(1-(y/x)\times(1/n))/(y/x)|$. For example, assuming that the resistors R1 and R2 are equal to the resistor R5 (i.e. $x = y = 1$) and the resistor R4 is twice as big as the resistor R5 (i.e. $n = 2$), the noise and distortion caused by the amplifier 230 can be cancelled completely. Specifically, the noise and distortion caused by the amplifier 230 can be decreased by appropriately controlling the ratio of the resistors R1, R2, R4 and R5. It should be noted that, x, y, m and n of the embodiments are not limited to an integer.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art), the scope of the invention being defined by the appended claims.

**Claims**

1. A single-ended to differential conversion circuit (210) for converting an input signal into a pair of differential signals, comprising:

   an amplifier (230), comprising an inverting input terminal, a non-inverting input terminal for receiving a reference signal ($V_{ref}$), and an output terminal;
   a first resistor (R1) coupled between the inverting input terminal and the output terminal of the amplifier (230);
   a second resistor (R2) coupled to the inverting input terminal of the amplifier (230), wherein the inverting input terminal of the amplifier (230) is configured to receive the input signal via the second resistor (R2);
   a third resistor (R3) coupled to the output terminal of the amplifier (230); **characterized in that** it also comprises a resistor string coupled between the output terminal of the amplifier (230) and the end of the second resistor (R2) that is configured to receive the input signal,
   the resistor string comprising a fourth resistor (R4) and a fifth resistor (R5) connected in series,
   wherein a signal of the pair of differential signals is configured to be provided via the third resistor (R3), and another signal of the pair of differential signals is configured to be provided via the connection point between the fourth transistor (R4) and the fifth resistor (R5).

2. The single-ended to differential conversion circuit as claimed in claim 1, further comprising:

   a sixth resistor (R6) coupled to the second resistor and the resistor string, configured to receive the input signal, wherein the second resistor is coupled between the sixth resistor and the inverting input terminal of the amplifier, and the fifth resistor is coupled between the sixth resistor and the fourth resistor.

3. The single-ended to differential conversion circuit as claimed in claim 1 or 2, wherein the sum of a first current flowing through the fifth resistor and a second current flowing through the fourth resistor is configured to be equal to a third current flowing through the third resistor.

4. The single-ended to differential conversion circuit as claimed in claim 1 or 2, wherein common mode output impedances of the single-ended to differential conversion circuit are equal.

5. The single-ended to differential conversion circuit as claimed in claim 1 or 2, wherein differential mode output impedances of the single-ended to differential conversion circuit are equal.

6. The single-ended to differential conversion circuit as claimed in any one of claims 1-5, wherein the resistance of the fifth resistor is $R$, the resistance of the fourth resistor is $n \times R$, the resistance of the second resistor is $x \times R$, the resistance of the first resistor is $y \times R$, and the resistance of the third resistor is $\dfrac{\frac{y}{x}}{1-\frac{y}{x}\frac{1}{n}} \times R$ .

7. The single-ended to differential conversion circuit as claimed in any one of the preceding claims, wherein the reference signal is configured to have a constant voltage value.

8. A signal processing module (200), comprising:

a differential signal processing circuit (220), configured to provide a pair of differential output signals ($OUT_P$, $OUT_N$)according to a pair of differential intermediate signals ($V_{CM} + V_P$), $V_{CM} +V_N$), comprising:
a fully-differential amplifier (220); and
a single-ended to differential conversion circuit (210) according to one of claims 1 - 7 for providing the pair of differential intermediate signals ($V_{CM} + V_P$), $V_{CM} +V_N$),.

9. The signal processing module as claimed in claim 8, wherein an intermediate signal of the pair of differential intermediate signals is configured to be provided to the non-inverting input terminal of the fully-differential amplifier via the third resistor, and another intermediate signal of the pair of differential output signals is configured to be provided to the inverting input terminal of the fully-differential amplifier via the fourth and fifth resistors.

**Patentansprüche**

1. Einfachend-Differenzialumwandlungsschaltung (210) zum Umwandeln eines Eingangssignals in ein Paar von Differenzsignalen, umfassend:

einen Verstärker (230), der einen invertierenden Eingangsanschluss, einen nicht-invertierenden Eingangsanschluss zum Empfangen eines Referenzsignals ($V_{ref}$) und einen Ausgangsanschluss umfasst;
einen ersten Widerstand (R1), der zwischen dem invertierenden Eingangsanschluss und dem Ausgangsanschluss des Verstärkers (230) gekoppelt ist;
einen zweiten Widerstand (R2), der mit dem invertierenden Eingangsanschluss des Verstärkers (230) gekoppelt ist, wobei der invertierende Eingangsanschluss des Verstärkers (230) so ausgebildet ist, um das Eingangssignal über den zweiten Widerstand (R2) zu empfangen;
einen dritten Widerstand (R3), der mit dem Ausgangsanschluss des Verstärkers (230) gekoppelt ist;
**dadurch gekennzeichnet, dass** er auch eine Widerstandskette umfasst, die zwischen dem Ausgangsanschluss des Verstärkers (230) und dem Ende des zweiten Widerstandes (R2), der zum Empfang des Eingangssignals ausgebildet ist, gekoppelt ist,
wobei die Widerstandskette einen vierten Widerstand (R4) und einen fünften Widerstand (R5) umfasst, die in Reihe geschaltet sind,
wobei ein Signal des Paars von Differenzsignalen ausgebildet ist, um über den dritten Widerstand (R3) bereitgestellt zu werden, und wobei ein weiteres Signal des Paars von Differenzsignalen ausgebildet ist, um über den Verbindungspunkt zwischen dem vierten Transistor (R4) und dem fünften Widerstand (R5) bereitgestellt zu werden.

2. Einfachend-Differenzialumwandlungsschaltung nach Anspruch 1, weiterhin umfassend:

einen sechsten Widerstand (R6), der an den zweiten Widerstand und die Widerstandskette gekoppelt ist und ausgebildet ist, um das Eingangssignal zu empfangen,
wobei der zweite Widerstand zwischen den sechsten Widerstand und den invertierenden Eingangsanschluss des Verstärkers gekoppelt ist, und der fünfte Widerstand zwischen den sechsten Widerstand und den vierten Widerstand gekoppelt ist.

3. Einfachend-Differenzialumwandlungsschaltung nach Anspruch 1 oder 2, wobei die Summe eines ersten durch den fünften Widerstand fließenden Stroms und eines zweiten durch den vierten Widerstand fließenden Stroms ausgebildet ist, um gleich einem dritten Strom zu sein, der durch den dritten Widerstand fließt.

4. Einfachend-Differenzialumwandlungsschaltung nach Anspruch 1 oder 2, wobei die Gleichtakt-Ausgangsimpedanzen der Einfachend-Differenzialumwandlungsschaltung gleich sind.

5. Einfachend-Differenzialumwandlungsschaltung nach Anspruch 1 oder 2, wobei die Differentialmodus-Ausgangsimpedanzen der Einfachend-Differenzialumwandlungsschaltung gleich sind.

6. Einfachend-Differenzialumwandlungsschaltung nach einem der Ansprüche 1 bis 5, wobei der Widerstand des fünften Widerstandes R ist, der Widerstand des vierten Widerstandes $n \times R$ ist, der Widerstand des zweiten Widerstandes $x \times R$, der Widerstand des ersten Widerstandes $y \times R$ ist, und der Widerstand des dritten Widerstandes $\frac{\frac{y}{x}}{1 - \frac{y1}{xn}} \times R$ ist.

7. Einfachend-Differenzialumwandlungsschaltung nach einem der vorangehenden Ansprüche, wobei das Referenzsignal ausgebildet ist, um einen konstanten Spannungswert zu haben.

8. Signalverarbeitungsmodul (200), umfassend:

eine Differenzsignalverarbeitungsschaltung (220), die ausgebildet ist, um ein Paar von differentiellen Ausgangssignalen ($OUT_P$, $OUT_N$) entsprechend einem Paar von differentiellen Zwischensignalen ($V_{CM} + V_P$), $V_{CM} + V_N$) bereitzustellen, umfassend:

einen Voll-Differenzverstärker (220); und
eine Einfachend-Differenzialumwandlungsschaltung (210) nach einem der Ansprüche 1 bis 7 zur Bereitstellung des Paars von differentiellen Zwischensignalen ($V_{CM} + V_P$), $V_{CM} + V_N$).

9. Signalverarbeitungsmodul nach Anspruch 8, wobei ein Zwischensignal des Paares von differentiellen Zwischensignalen ausgebildet ist, um über den dritten Widerstand dem nicht-invertierenden Eingangsanschluss des Voll-Differenzverstärkers zugeführt zu werden, und wobei ein weiteres Zwischensignal des Paares von differentiellen Ausgangssignalen ausgebildet ist, um über den vierten und fünften Widerstand dem invertierenden Eingangsanschluss des Voll-Differenzverstärkers zugeführt zu werden.

## Revendications

1. Circuit de conversion asymétrique-différentiel (210) pour convertir un signal d'entrée en une paire de signaux différentiels, comprenant :

un amplificateur (230), comprenant une borne d'entrée inverseuse, une borne d'entrée non inverseuse pour recevoir un signal de référence ($V_{ref}$), et une borne de sortie ;
une première résistance (R1) couplée entre la borne d'entrée inverseuse et la borne de sortie de l'amplificateur (230) ;
une deuxième résistance (R2) couplée à la borne d'entrée inverseuse de l'amplificateur (230), dans lequel la borne d'entrée inverseuse de l'amplificateur (230) est configurée pour recevoir le signal d'entrée via la deuxième résistance (R2) ;
une troisième résistance (R3) couplée à la borne de sortie de l'amplificateur (230) ;
**caractérisé en ce qu'**il comprend également
une chaîne de résistances couplée entre la borne de sortie de l'amplificateur (230) et l'extrémité de la deuxième résistance (R2) qui est configurée pour recevoir le signal d'entrée,
la chaîne de résistances comprenant une quatrième résistance (R4) et une cinquième résistance (R5) connectées en série,
dans lequel un signal de la paire de signaux différentiels est configuré pour être délivré via la troisième résistance (R3), et un autre signal de la paire de signaux différentiels est configuré pour être délivré via le point de connexion entre la quatrième résistance (R4) et la cinquième résistance (R5).

2. Circuit de conversion asymétrique-différentiel selon la revendication 1, comprenant en outre :

une sixième résistance (R6) couplée à la deuxième résistance et à la chaîne de résistances, configurée pour recevoir le signal d'entrée,

dans lequel la deuxième résistance est couplée entre la sixième résistance et la borne d'entrée inverseuse de l'amplificateur, et la cinquième résistance est couplée entre la sixième résistance et la quatrième résistance.

3. Circuit de conversion asymétrique-différentiel selon la revendication 1 ou 2, dans lequel la somme d'un premier courant circulant à travers la cinquième résistance et d'un deuxième courant circulant à travers la quatrième résistance est configurée pour être égale à un troisième courant circulant à travers la troisième résistance.

4. Circuit de conversion asymétrique-différentiel selon la revendication 1 ou 2, dans lequel des impédances de sortie de mode commun du circuit de conversion asymétrique-différentiel sont égales.

5. Circuit de conversion asymétrique-différentiel selon la revendication 1 ou 2, dans lequel des impédances de sortie de mode différentiel du circuit de conversion asymétrique-différentiel sont égales.

6. Circuit de conversion asymétrique-différentiel selon l'une des revendications 1 à 5, dans lequel la résistance de la cinquième résistance est $R$, la résistance de la quatrième résistance est $n \times R$, la résistance de la deuxième résistance est $x \times R$, la résistance de la première résistance est $y \times R$, et la résistance de la troisième résistance

est $\dfrac{\dfrac{y}{x}}{1-\dfrac{y}{x}\dfrac{1}{n}} \times R$ .

7. Circuit de conversion asymétrique-différentiel selon l'une des revendications précédentes, dans lequel le signal de référence est configuré pour avoir une valeur de tension constante.

8. Module de traitement de signal (200), comprenant :

un circuit de traitement de signal différentiel (220), configuré pour délivrer une paire de signaux de sortie différentiels $(OUT_P, OUT_N)$ selon une paire de signaux intermédiaires différentiels $(V_{CM} + V_P)$, $V_{CM} + V_N)$, comprenant :

un amplificateur entièrement différentiel (220) ; et
un circuit de conversion asymétrique-différentiel (210) selon l'une des revendications 1 à 7 pour délivrer la paire de signaux intermédiaires différentiels $(V_{CM} + V_P)$, $V_{CM} + V_N)$.

9. Module de traitement de signal selon la revendication 8, dans lequel un signal intermédiaire de la paire de signaux intermédiaires différentiels est configuré pour être délivré à la borne d'entrée non inverseuse de l'amplificateur entièrement différentiel via la troisième résistance, et un autre signal intermédiaire de la paire de signaux de sortie différentiels est configuré pour être délivré à la borne d'entrée inverseuse de l'amplificateur entièrement différentiel via les quatrième et cinquième résistances.

EP 3 139 502 B1

FIG. 1

FIG. 2

**EP 3 139 502 B1**

**REFERENCES CITED IN THE DESCRIPTION**

**Patent documents cited in the description**

- WO 0041297 A1